(19) Europäisches Patentamt
European Patent Office
Office européen des brevets

(11) **EP 1 959 484 A1**

(12) **EUROPEAN PATENT APPLICATION**
published in accordance with Art. 158(3) EPC

(43) Date of publication:
**20.08.2008 Bulletin 2008/34**

(51) Int Cl.:
***H01L 21/3065*** (2006.01)   ***H05H 1/46*** (2006.01)

(21) Application number: **06832680.0**

(22) Date of filing: **15.11.2006**

(86) International application number:
**PCT/JP2006/322749**

(87) International publication number:
**WO 2007/060867 (31.05.2007 Gazette 2007/22)**

(84) Designated Contracting States:
**DE FR NL**

(30) Priority: **25.11.2005 JP 2005340828**

(71) Applicant: **TOKYO ELECTRON LIMITED**
**Minato-ku**
**Tokyo 107-6325 (JP)**

(72) Inventors:
• **TIAN, Caizhong**
**Amagasaki-shi**
**Hyogo 660-0891 (JP)**

• **YUASA, Tamaki**
**Amagasaki-shi**
**Hyogo 660-0891 (JP)**
• **NOZAWA, Toshihisa**
**Amagasaki-shi**
**Hyogo 660-0891 (JP)**

(74) Representative: **Manitz, Finsterwald & Partner**
**GbR**
**Martin-Greif-Strasse 1**
**80336 München (DE)**

(54) **MICROWAVE INTRODUCTION DEVICE**

(57)    A microwave introduction device includes a microwave generator for generating a microwave of a predetermined frequency, a mode converter for converting the microwave into a predetermined oscillation mode, a planar antenna member arranged toward a predetermined space, and a coaxial waveguide connecting the mode converter with the planar antenna member to propagate the microwave. A central conductor of the coaxial waveguide is formed in a cylindrical shape, an inner diameter D1 of the central conductor is not smaller than a first predetermined value, and an outer conductor of the central conductor is also formed in a cylindrical shape. A ratio r1/r2 of a radius r1 of an inner diameter of the outer conductor to a radius r2 of an outer diameter of the central conductor is maintained at a second predetermined value and the inner diameter D2 the outer conductor is not greater than a third predetermined value.

FIG. 1

VACUUM EVACUATION
32

EP 1 959 484 A1

**Description**

[Technical Field]

The present invention relates to a microwave introduction device used for processing a semiconductor wafer or the like by applying thereon plasma generated by a microwave.

[Background Art]

Along with a recent trend of a high density and a high miniaturization of semiconductor devices, a plasma processing apparatus has been used for performing a film forming process, an etching process, an ashing process and the like in a manufacturing process of the semiconductor devices. Especially, since a plasma can be stably generated even in an environment of a high vacuum level in which a pressure is comparatively low, e.g., from about 0.1 mTorr (13.3 mPa) to several tens mTorr (several Pa), a microwave plasma apparatus for generating a high-density plasma by using a microwave tends to be used.

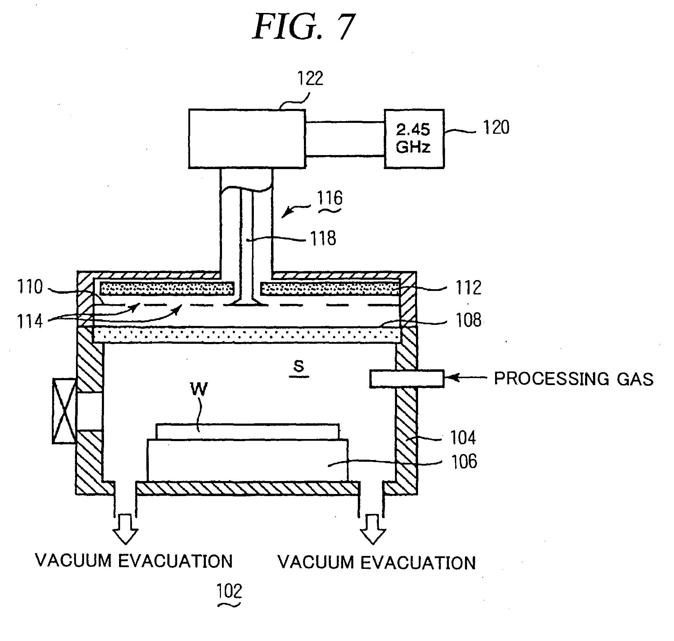

Such a plasma processing apparatus is disclosed in Japanese Patent Laid-open Publication Nos. H3-191073, H5-343334, H9-181052, 2003-332326, or the like. Herein, a typical microwave plasma processing apparatus using a microwave will be schematically described with reference to Fig. 7. Fig. 7 is a schematic configuration diagram illustrating a conventional typical microwave plasma processing apparatus.

As illustrated in Fig. 7, a plasma processing apparatus 102 has an evacuable processing chamber 104 and a mounting table 106 for mounting thereon a semiconductor wafer W in the processing chamber 104. Further, airtightly provided on a ceiling portion facing the mounting table 106 is a ceiling plate 108, made of, e.g., disc-shaped aluminum nitride, quartz, or the like, for transmitting a microwave.

Provided on or above a top surface of the ceiling plate 108 is a disc-shaped planar antenna member 110 having a thickness of several mm. Disposed on or above a top surface of the planar antenna member 110 is a slow-wave member 112 made of, e.g., a dielectric material, for shortening a wavelength of the microwave in a radial direction of the planar antenna member 110.

The planar antenna member 110 includes a plurality of microwave radiation holes 114 formed of through holes having, for example, a shape of an elongated groove. The microwave radiation holes 114 are generally arranged in a concentric or spiral pattern. Additionally, a central conductor 118 of a coaxial waveguide 116 is connected to a central portion of the planar antenna member 110, so that a microwave of, e.g., 2.45 GHz, generated by a microwave generator 120 can be guided to the planar antenna member 110 after being converted to a predetermined oscillation mode by a mode converter 122. With this configuration, the microwave is emitted from the microwave radiation holes 114 provided in the planar antenna member 110, and is transmitted through the ceiling plate 108, and is introduced into the processing chamber 104 while propagating along a radial direction of the antenna member 110 in a radial shape. By this microwave, a plasma is generated in a processing space S of the processing chamber 104, so that a plasma processing such as an etching, a film formation or the like can be performed on the semiconductor wafer W held on the mounting table 106.

Meanwhile, when a certain kind of plasma process, e.g., a plasma etching process, is performed by using the plasma processing apparatus, there may be a case that a film thickness of a film to be etched on a wafer surface needs to be measured in real time in order to check an end point of the etching process.

In general, a film thickness measuring device used for measuring a film thickness has employed a method (structure) of measuring the film thickness by emitting an inspection laser beam to a target object to be inspected and by detecting a reflected beam. If this film thickness measuring device is installed on the ceiling portion of the processing chamber 104, an insertion through hole for the laser beam may be formed in the planar antenna member 110 so that the laser beam can be irradiated to the wafer surface via the insertion through hole. However, if a new insertion through hole for the laser beam is installed in the planar antenna member 110 in addition to the plurality of microwave radiation holes 114 precisely arranged to be an appropriate distance apart, there is a likelihood that a microwave leaks or an adverse influence is exerted on a radiation of the microwave.

With regard to this point, it can be considered to make the central conductor 118, which passes through a center of the coaxial waveguide 116, empty state and also, to form a hollow passage therein. In Japanese Patent Laid-open Publication No. 2003-332326, an example of installing a gas flow path in an internal conductor 118 is disclosed.

However, each design dimension of the mode converter 122 and the coaxial waveguide 116 connected thereto is an optimized value for the microwave propagated by them. Therefore, a slight modification of each dimension may cause the microwave to have an unnecessary oscillation mode or a reflectivity of the microwave to be changed.

In particular, as for the coaxial waveguide 116 for propagating the microwave of, for example, 2.45 GHz used in the conventional plasma process apparatus, an optimized diameter of the central conductor 118 is about 16 mm. On the contrary, the inner diameter of the laser beam insertion through hole needs to be at least about 18 mm in order to pass the laser beam emitted from the film thickness measuring device therethrough and to receive the reflected beam by the film thickness measuring device. Therefore, with the design that the diameter of the central conductor 118 in the conventional plasma processing apparatus is about 16 mm, it is impossible to meet a dimension modification request as described above.

[Disclosure of the Invention]

Inventors of the present invention have focused their research on propagation of a microwave. As a result, the present invention has been derived by finding new design criteria capable of enlarging an inner diameter of a hollow passage formed in a central conductor while maintaining basic performances regarding the microwave propagation.

In view of the foregoing, the present invention is conceived to effectively solve the problems. An object of the present invention is to provide a microwave introduction device and a plasma processing apparatus using the same, wherein a hollow passage with a large inner diameter can be formed in a central conductor of a coaxial waveguide while basic performances regarding the microwave propagation are maintained, based on the new design criteria.

Further, another object of the present invention is to provide a plasma processing apparatus wherein a film thickness on a target object surface can be measured in real time by passing a laser beam from a film thickness measuring device through the hollow passage formed in the central conductor.

In accordance with the present invention, there is provided a microwave introduction device including a microwave generator for generating a microwave of a predetermined frequency, a mode converter for converting the microwave into a predetermined oscillation mode, a planar antenna member arranged toward a predetermined space, and a coaxial waveguide connecting the mode converter with the planar antenna member to propagate the microwave, wherein a central conductor of the coaxial waveguide is formed in a cylindrical shape, an inner diameter D1 of the central conductor is not smaller than a first predetermined value, an outer conductor of the coaxial waveguide is also formed in a cylindrical shape, a ratio r1/r2 of a radius r1 of an inner diameter of the outer conductor to a radius r2 of an outer diameter of the central conductor is maintained at a second predetermined value, and the inner diameter D2 of the outer conductor is not greater than a third predetermined value.

In accordance with the present invention, by maintaining the ratio r1/r2 of the radius r1 of the inner diameter of the outer conductor to the radius r2 of the outer diameter of the central conductor at a second predetermined value, while basic performances regarding the microwave propagation are maintained, a hollow passage with a large inner diameter can be formed in the central conductor of the coaxial waveguide.

For example, a through hole communicated with the inside of the cylinder-shaped central conductor can be formed at a center portion of the planar antenna member.

Further, for instance, the predetermined oscillation mode is a TEM mode.

Furthermore, for example, the first predetermined value is about 16 mm.

Also, for example, the second predetermined value is a specific value within the range of about $e^{2/3}$ to e (e = 2.718...).

In addition, for instance, a characteristic impedance obtained based on the ratio r1/r2 is within the range of about 40 to 60 $\Omega$.

Further, for example, the third predetermined value is a (0.59 - 0.1) wavelength of a wavelength $\lambda_0$ of the microwave under the atmospheric pressure.

Moreover, for example, the entire length including the mode converter and the coaxial waveguide is set to an odd number multiple of 1/4 wavelength of a wavelength $\lambda_0$ of the microwave under the atmospheric pressure.

Further, for example, a base end of the central conductor is provided via a cone-shaped connection member formed on a partition wall of the mode converter, and a distance between an end surface located in an inner side of a progressive direction of the microwave entering the mode converter and a middle point of an inclined surface of the cone-shaped connection member is set to a length of an integer multiple of 1/2 wavelength of a wavelength $\lambda_0$ of the microwave under the atmospheric pressure.

Furthermore, for example, an inner diameter D1 of the central conductor is not smaller than about 18 mm.

Also, for instance, the frequency of the microwave is about 2.45 GHz.

Additionally, for example, on a top surface of the planar antenna member, a slow-wave member is installed.

Moreover, in accordance with the present invention, there is provided a plasma processing apparatus including a processing chamber whose ceiling portion is opened and the inside thereof can be evacuated to vacuum, a mounting table, installed in the processing chamber, for mounting a target object to be processed, a ceiling plate which is made of a microwave transmissive dielectric material and is airtightly mounted to an opening of the ceiling portion, a gas introduction unit for introducing a predetermined gas into the processing chamber, and a microwave introduction device having any one of the above-mentioned features, disposed on the ceiling plate, for generating plasma in the processing chamber by a microwave.

Desirably, installed at the microwave introduction device is a film thickness measuring device for measuring a thickness of a film on a surface of the target object by emitting a laser beam along a hollow passage of the central conductor of the coaxial waveguide in the microwave introduction device.

In this case, the film thickness of the target object surface can be measured in real time while basic performances regarding the microwave propagation are maintained.

[Brief Description of the Drawings]

Fig. 1 provides a configuration view of a plasma processing apparatus in accordance with an embodiment of the present invention.

Fig. 2 presents a plan view of a planar antenna member of the plasma processing apparatus described in Fig. 1.
Fig. 3 illustrates an enlarged cross-sectional view of a microwave introduction device of the plasma processing apparatus depicted in Fig. 1.
Fig. 4 shows a cross-sectional view taken along the line A-A in Fig. 3.
Fig. 5 depicts a plan view of a mode converter of the plasma processing apparatus illustrated in Fig. 1.
Fig. 6A presents a photograph showing a simulated electric field distribution for the microwave introduction device in accordance with the embodiment of the present invention.
Fig. 6B provides a photograph showing a simulated electric field distribution for a conventional microwave introduction device.
Fig. 7 sets forth a schematic configuration view of a conventional typical plasma processing apparatus.

[Best Mode for Carrying out the Invention]

Hereinafter, a microwave introduction device and a plasma processing apparatus in accordance with an embodiment of the present invention will be described in detail with reference to the accompanying drawings.

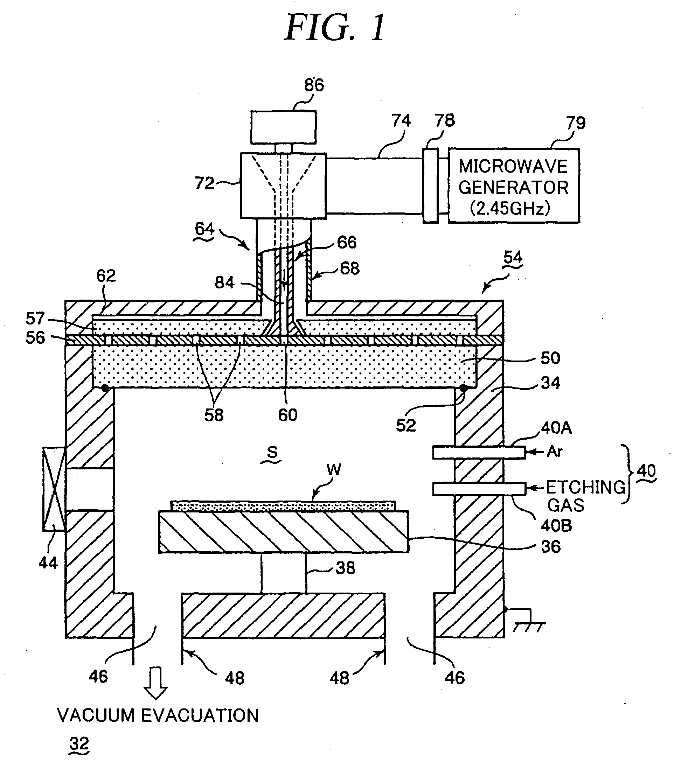

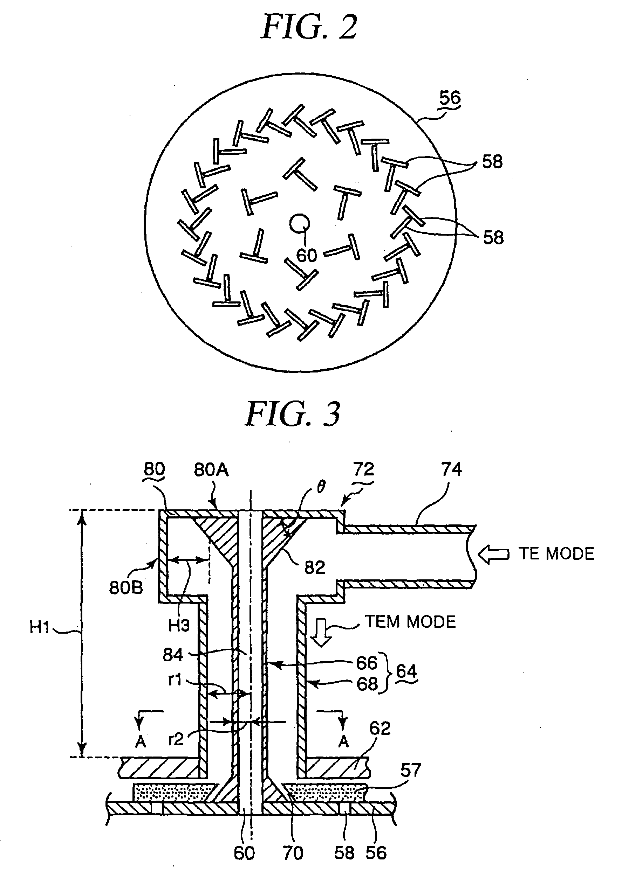

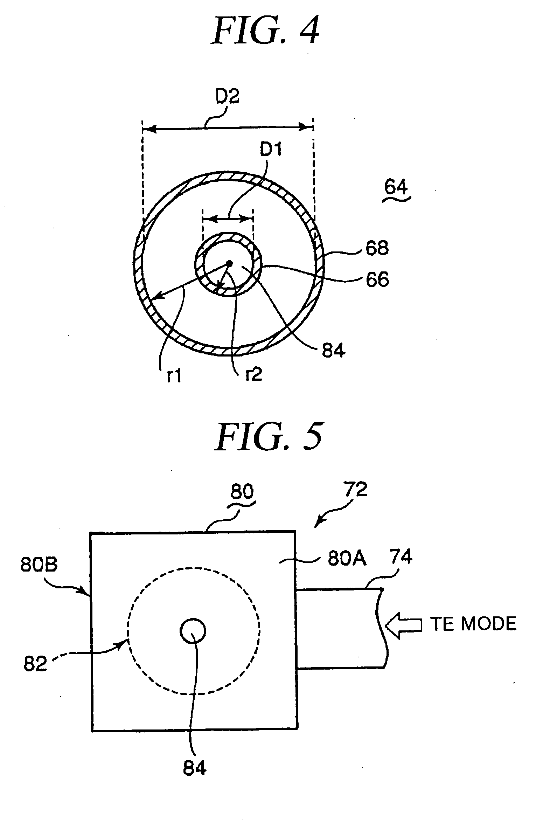

Fig. 1 provides a configuration view of a plasma processing apparatus in accordance with an embodiment of the present invention. Fig. 2 presents a plan view of a planar antenna member of the plasma processing apparatus described in Fig. 1. Fig. 3 illustrates an enlarged cross-sectional view of a microwave introduction device of the plasma processing apparatus depicted in Fig. 1. Fig. 4 shows a cross-sectional view taken along the line A-A in Fig. 3. Fig. 5 depicts a plan view of a mode converter of the plasma processing apparatus illustrated in Fig. 1. Herein, an etching process will be described as an example of a plasma process.
As shown in Fig. 1, a plasma processing apparatus (plasma etching apparatus) 32 in accordance with the embodiment of the present invention includes a processing chamber 34 formed in a cylindrical shape as a whole. A sidewall and a bottom portion of the processing chamber 34 are made of a conductor such as aluminum or the like, and are grounded. The inside of the processing chamber 34 is configured as an airtightly sealed processing space S, and plasma is generated in this processing space S.
Disposed inside the processing chamber 34 is a mounting table 36 for mounting a target object to be processed, e.g., semiconductor wafer W, on a top surface thereof. The mounting table 36 is of a flat circular-plate shape made of, for example, alumite-treated aluminum or the like. The mounting table 36 is sustained on a supporting column 38 which is made of, for example, insulating materials and stands on the bottom portion of the processing chamber 34.
Installed on the top surface of the mounting table 36 is an electrostatic chuck or a clamp device (not shown) for holding the semiconductor wafer W. The mounting table 36 may be connected to a high frequency bias power supply of, e.g., 13.56 MHz. Further, if necessary, the mounting table 36 may have therein a heater.
Installed at the sidewall of the processing chamber 34 is a plasma gas supply nozzle 40A made of, e.g., a quartz pipe to supply a plasma gas such as an Ar gas into the processing chamber 34 as a gas introduction unit 40. Further, disposed at the sidewall of the processing chamber 34 is a processing gas supply nozzle 40B made of, e.g., a quartz pipe to supply a processing gas such as an etching gas into the processing chamber 34. Each of the gases can be supplied through each of the nozzles 40A and 40B when necessary, while its flow rate is being controlled.
Installed at the sidewall of the processing chamber 34 is a gate valve 44 which can be opened/closed, whereby the wafer is loaded into or unloaded from the inside of the processing chamber 34. Further, a gas exhaust port 46 is provided at the bottom portion of the processing chamber 34. Connected to the gas exhaust port 46 is a gas exhaust path 48 on which a vacuum pump (not shown) is provided. With this arrangement, the inside of the processing chamber 34 can be evacuated to a specific pressure level as required.
Moreover, a ceiling portion of the processing chamber 34 is opened (or has an opening). A microwave transmissive ceiling plate 50 is airtightly provided at the opening via a sealing member 52 such as an O ring. The ceiling plate 50 is made of, for example, quartz, a ceramic material, or the like. The thickness of the ceiling plate 50 is set to be, for example, about 20 mm in consideration of pressure resistance.
Disposed on a top surface of the ceiling plate 50 is a microwave introduction device 54 in accordance with the present embodiment. Specifically, the microwave introduction device 54 has a planar antenna member 56 of a circular-plate shape installed on a top surface of the ceiling plate 50. The planar antenna member 56 is disposed toward the processing space S and a microwave is introduced into the processing space S, as described later. Additionally, a plate-shaped slow-wave member 57 having a high-permittivity property is disposed on the upper side of the planar antenna member 56. The slow-wave member 57 serves to shorten the wavelength of the propagating microwave.

In case of a wafer having a size of 8 inch, the planar antenna member 56 is made of a conductive material having a diameter of, e.g., about 300 to 400 mm and a thickness of, e.g., about 1 to several mm. More specifically, the planar antenna member 56 can be made of, e.g., an aluminum plate or a copper plate whose surface is plated with silver. Further, the planar antenna member 56 is provided with a plurality of microwave radiation holes 58 formed of through holes having, for example, a shape of an elongated groove, as illustrated in Fig. 2. An arrangement pattern of the microwave radiation holes 58 is not particularly limited. For instance, they can be arranged in a concentric, spiral or radial pattern or can be uniformly distributed over the entire surface of the planar antenna member. For example, as illustrated in Fig. 2, a pair is made by arranging two microwave radiation holes 58 in a T-shape with a little space therebetween, and by arranging 6 pairs in the center portion and 24 pairs in the peripheral portion, an arrangement of two concentric circles is realized as a whole.

Formed at the central portion of the planar antenna member 56 is a through hole 60 having a predetermined size. As described later, a laser beam for measuring a film thickness is inserted and passed via the through hole 60.

Referring back to Fig. 1, a substantially entire surface of a top portion and a sidewall portion of the slow-wave member 57 is enclosed by a waveguide box 62 made of a conductive vessel in a hollow cylindrical shape. The planar antenna member 56 is configured as a bottom plate of the waveguide box 62, and is provided to face the mounting table 36.

All peripheral portions of the waveguide box 62 and the planar antenna member 56 are electrically connected with the processing chamber 34 and are grounded. Further, an outer conductor 68 of a coaxial waveguide 64, which is an inventive feature of the present invention, is connected to the top surface of the waveguide box 62. The coaxial waveguide 64 is configured of a central conductor 66 and the outer conductor 68 which is in, for example, a cylinder shape whose cross section is a circle and is installed to wrap around the central conductor 66 in a coaxial shape by having a predetermined space between the central conductor 66 and the outer conductor 68. The central conductor 66 and the outer conductor 68 are made of, for example, conductors such as stainless steel, copper, or the like. To the center of the top portion of the waveguide box 62, the cylinder-shaped outer conductor 68 of the coaxial waveguide 64 is connected, and the central conductor 66 in the outer conductor is connected to the center portion of the planar antenna member 56 through a hole 70 formed in the center of the slow-wave member 57.

The coaxial waveguide 64 is connected to a microwave generator 79 for generating a microwave of, e.g., about 2.45 GHz via a waveguide 74 on which a mode converter 72 and a matching circuit 78 are installed. The coaxial waveguide 64 with this arrangement serves to transmit the microwave to the planar antenna member 56. The frequency of the microwave is not limited to about 2.45 GHz, but another frequency, e.g., about 8.35 GHz, can be used.

As for the waveguide 74, a waveguide whose cross section is a circular or rectangular shape can be used. Also, on the top portion of the waveguide box 62, a ceiling cooling jacket (not shown) may be installed. And then, inside of the waveguide box 62, the slow-wave member 57, which is installed on the top side of the planar antenna member 56 and has a high permittivity property, shortens the wavelength of the microwave by the wavelength shortening effect. Further, for the slow-wave member 57, for example, quartz or aluminum nitride can be used.

Here, a structure of the coaxial waveguide 64, which is an inventive feature of the present invention, will be described with reference to Figs. 3 to 5 in more detail.

In accordance with the present embodiment, an oscillation mode of a microwave generated from the microwave generator 79 is converted from a TE mode to a TEM mode in the mode converter 72, and also, a moving direction of the microwave is curved by 90 degree. An external partition wall 80 of the mode converter 72 is formed in a rectangular shaped box body, as illustrated in Fig. 5. Further, a base end, which is the upper end portion of the central conductor 66 of the coaxial waveguide 64, is formed of a cone-shaped connection member 82 whose upper diameter is large, and is connected to a partition wall 80A which is the ceiling plate of the mode converter 72. An inclined angle $\theta$ of the conic side of the cone-shaped connection member 82 is set to about 45 degree in order to make the microwave, which progresses from the waveguide 74, face downward by curving its progressing direction by 90 degree.

In comparison with the conventional plasma processing apparatus, diameters of the central conductor 66 and the outer conductor 68 of the coaxial waveguide 64 are set larger within the scope capable of maintaining basic performances related to the microwave propagation. In addition, the central conductor 66 is in an empty (cavity) state inside and a hollow passage 84, whose inner diameter D1 is set to above a first determined value, is formed in a longitudinal direction within the central conductor 66. The lower end portion of the hollow passage 84 is communicated with the central through hole 60 of the planar antenna member 56 (see Fig. 2). Here, the first determined value is about 16 mm, i.e., a general thickness of the central conductor of the conventional microwave generating apparatus. That is, the inner diameter D1 is set to a value larger than about 16 mm.

Further, each thickness of the central conductor 66 and the outer conductor 68 is set to be at least about 2 mm. If its thickness is thinner than that, it causes heating by the microwave.

Here, only if the diameters of the central conductor 66 and the outer conductor 68 are set to be large simply, there is a likelihood that the microwave has plural oscillation modes, a reflectivity of the microwave is degraded, or the like. Thus, it is necessary to satisfy design criteria as explained below.

In first criteria, a ratio (r1 / r2) of a radius r1 of the inner diameter of the outer conductor 68 and a radius r2 of the outer diameter of the central conductor 66 is maintained as a second predetermined value, and the inter diameter D2 (= 2 x r1) of the outer conductor 68 is regarded as below a third predetermined value.

In such case, a characteristic impedance $Z_o$, which is obtained based on the following Equation 1 and the above ratio (r1 / r2), is required to fall within the range of, for example, about 40 ~ 60 Ω. Specifically, the second predetermined value satisfying such a characteristic impedance value is a fixed value within the range of $e^{2/3}$ ~ e (e = 2.718...).

$$Z_o = h / 2\pi \cdot \ln(r1 / r2) \quad \text{.........Equation 1}$$

h : wave impedance (ratio of electric field to magnetic field)
ln: Natural Logarithm
(In Equation 1, in case of $40 \leq Z_o \leq 60$, the range of the ratio r1 / r2 is determined.)
Additionally, a method of obtaining a characteristic impedance on the coaxial line and a propagation of a microwave limited to the TEM mode is described in detail in「Coaxial Line」(pages 67 - 70) of a publication「Microwave Engineering」 (Morikita Electrical Engineering Series 3, Microwave Optics - Foundation and Principles - Writer: Nakajima Masamitsu, Publisher: Morikita Publication, published on Dec. 18, 1998). Therefore, its explanation is omitted here.

Also, the third predetermined value is a「0.59 - 0.1」(= 0.49) wavelength of an atmospheric wavelength $\lambda_0$ of the transmitted microwave by considering an experimental safety factor. Here, as shown in the following Equation 2, the inner diameter D2 is set to be below $0.49 \times \lambda_0$.

$$D2 \leq \lambda_0 (0.59 - 0.1) \quad \text{.........Equation 2}$$

By satisfying this condition, the oscillation mode of the microwave propagated within the coaxial waveguide 64 after a mode conversion can become only the TEM mode in which other oscillation modes are not present.

The conditional Equation shown in Equation 2 is obtained as follows. That is, besides the TEM mode, the easiest mode to transmit a microwave through a circular waveguide (not the coaxial waveguide) is a TE11 mode from the higher transmission coefficient, and in this case, a cutoff frequency is shown by following Equation.

$$Fc = 1.841 / 2\pi r \sqrt{(\mu \varepsilon)}$$

Here, the fc, r, $\mu$, $\varepsilon$ are the cutoff frequency, a radius of the circular waveguide, an atmospheric permeability, an atmospheric permittivity, respectively.

If this Equation is converted, it becomes r = $0.295 \lambda_0$ ($\lambda_0$ : an atmospheric wavelength of a microwave), and the diameter of the circular waveguide becomes 2r = $0.59 \lambda_0$.

Here, if a microwave having a wavelength longer than $\lambda_0$ is used, only the TEM mode is transmitted. Also, if the circular waveguide is considered as a coaxial waveguide, only the TEM mode is transmitted under condition of 2r $\fallingdotseq$ 2r1 = D2 $\leq$ 0.59 $\lambda_0$. Further, if an experimental safety factor is considered, it becomes 'D2 $\leq$ (0.59 - 0.1) $\lambda_0$' so that Equation 2 is derived.

As a result, the inner diameter D2 : (2 x r1) of the outer conductor 68 can be maximum about 60 mm, and also, the outer diameter (2 x r2) of the central conductor 66 can be about 30 mm. If the thickness of the central conductor 66 becomes about 2 mm, the inner diameter D1 can be about 26 mm.

Furthermore, as shown in the following Equation 3 as second criteria, it is desirable to set the total length H1 including the mode converter 72 and the coaxial waveguide 64 to an odd number multiple of 1/4 wavelength of the atmospheric wavelength $\lambda_0$ of the microwave.

$$H1 = 1/4 \times \lambda_0 \times (2n - 1) \quad \text{.........Equation 3}$$

n : positive integer
The height H1 is, specifically, a distance between the partition wall 80A of the ceiling of the mode converter 72 and the ceiling plate of the waveguide box 62. By satisfying the second criteria, the progressive wave which progress through the coaxial waveguide 64 and the reflected wave from the planar antenna member 56 can be cancelled efficiently.

Moreover, as shown in Equation 4 as third criteria, it is desirable to set a distance H3 between a short-circuit plate 80B, which is in an end surface (left end surface of Fig 3.) located in an inner side of the progressive direction of the microwave entering the mode converter 72, and the middle point of the conic surface of the corresponding side of the connection member 82 to a length of an integer multiple of 1/2 wavelength of the atmospheric wavelength $\lambda_0$ of the microwave.

$$H3 = 1/2 \times \lambda_0 \times n \dots\dots\text{Equation 4}$$

n : positive integer

Here, the middle point of the cone-shaped inclined surface of the connection member 82 is located on a line extended in the vertical direction of the cylinder-shaped outer conductor 68 of the coaxial waveguide 64.

By satisfying the third criteria, the progressive wave transmitted from the inside of the waveguide 74 and the reflection wave reflected from the short-circuit plate 80B of the mode converter 72 are synchronized to be effectively combined, and the combined wave can progress to the downward coaxial waveguide 64 (by changing its progressive direction by 90 degree).

As described above, by satisfying the first criteria, the inner diameter of the hollow passage 84 formed in the central conductor can be enlarged while maintaining basic performances regarding the microwave. Also, by satisfying the second and third criteria, the above-mentioned effect can be more improved.

Referring back to Fig. 1, at the upper portion of the mode converter 72, a film thickness measuring device 86 is installed to measure a film thickness of a wafer surface by using a laser beam. With this configuration, a laser beam for a film thickness inspection can be emitted along the hollow passage 84 formed in the central conductor 66. Further, the film thickness measuring device 86 receives the reflected laser beam from the wafer to measure the film thickness of the wafer.

Hereinafter, a processing method (etching method) performed by using the plasma processing apparatus 32 configured as mentioned above will be explained.

First, a semiconductor wafer W is accommodated into the processing chamber 34 by a transferring arm (not shown) after passing through a gate valve 44. By moving a lifter pin (not shown) up and down, the semiconductor wafer W is mounted on the mounting surface, which is the top surface of the mounting table 36.

Further, for example, an Ar gas is supplied from the plasma gas supply nozzle 40A of the gas introduction unit 40 into the processing chamber 34, while its flow rate is being controlled. At the same time, for example, an etching gas is supplied from the processing gas supply nozzle 40B of the gas introduction unit 40 into the processing chamber 34, while its flow rate is being controlled. Also, the inside of the processing chamber 34 is maintained at a certain process pressure degree, for example, ranging from about 0.01 to several Pa.

At the same time, the microwave of the TE mode generated by the microwave generator 79 of the microwave introduction device 54 is transmitted to the mode converter 72 through the waveguide 74. Here, the oscillation mode is converted to the TEM mode, and the microwave is provided to the planar antenna member 56 through the coaxial waveguide 64. From the planar antenna member 56 to the processing space S, the microwave whose wavelength is shortened by the slow-wave member 57 is introduced. As a result, plasma is generated in the processing space S so that a predetermined etching process is performed.

Here, the microwave of, for example, 2.45 GHz generated from the microwave generator 79 is transmitted through the coaxial waveguide 64 and then transmitted to the planar antenna member 56 in the waveguide box 62 as described above. When the microwave is propagated from the center portion of the disc-shaped planar antenna member 56 to a peripheral portion in a radial shape, the microwave is transmitted through the ceiling plate 50 from the plurality of microwave radiation holes 58 formed in the planar antenna member 56 and introduced into the processing space S directly under the planar antenna member 56. By this microwave, the argon gas is excited and converted to plasma and diffused in a downward direction, and an active species is generated by activating the etching gas. Then, the film of the surface of the wafer W is etched by the active species.

Here, during the etching process, a laser beam for a film thickness inspection is emitted from the film thickness measuring device 86 installed on the top portion of the mode converter 72. This laser beam is passed through the hollow passage 84 formed in the central conductor 66 of the coaxial waveguide 64; is passed through the through hole 60 disposed in the center portion of the planar antenna member 56; is transmitted through the transparent ceiling plate 50 made of quartz; and then, is irradiated to the surface of the wafer W on the mounting table 36. Further, the reflected beam of the laser beam from the surface of the wafer W is incident into the film thickness measuring device 86 via the opposite path to the above-described path. Accordingly, a film thickness can be measured in real time during the etching process.

Then, when a measured value by the film thickness measuring device 86 is reduced to a predetermined film thickness, an end point is recognized. At that time, a control unit (not shown) terminates the etching process. Here, if a film thickness is measured by the film thickness measuring device 86 with a laser beam, the inner diameter D1 of the hollow passage 84 in the central conductor 66 needs to be equal to or more than about 16 mm, desirably, about 18 mm. Regarding this point, in accordance with the present embodiment, the inner diameter D1 of the hollow passage 84 can be enlarged while maintaining basic performances related to the microwave propagation, i.e., efficiently cancelling the reflected wave without having the other oscillation modes except the TEM mode, and also, efficiently supplying a microwave as described above.

To be specific, as described above, only if the diameters of the central conductor 66 and the outer conductor 68 are set to be large simply, there is a likelihood that the microwave has plural oscillation modes, a reflectivity of the microwave is degraded, or the like. Thus, it is necessary to satisfy the design criteria, which is an inventive feature of the present invention.

In first criteria, a ratio (r1 / r2) of a radius r1 of the inner diameter of the outer conductor 68 to a radius r2 of the outer diameter of the central conductor 66 is maintained as a second predetermined value, and the inter diameter D2 ($= 2 \times r1$) of the outer conductor 68 is regarded as below a third predetermined value.

In such case, a characteristic impedance $Z_o$, which is obtained based on the Equation 1 and the above ratio (r1 / r2), is required to fall within the range of, for example, about 40 ~ 60 Ω. Specifically, the second predetermined value satisfying such a characteristic impedance value is a fixed value within the range of $e^{2/3}$ ~ e (e = 2.718...).

Typically, the characteristic impedance $Z_o$ of the coaxial waveguide 64 becomes about 50 Ω and thus the whole microwave generator is constructed. Therefore, it is desirable to set a value of the characteristic impedance $Z_o$ to, for example, about 50 Ω in the present embodiment. As a result, the impedance matching can be achieved in the propagating path of the microwave. Further, in case that the Equation 1 is not satisfied, an impedance mismatching occurs and it considerably reduces power efficiency.

Further, the third predetermined value is a ⌈0.59 - 0.1 ⌋ (= 0.49) wavelength of an atmospheric wavelength $\lambda_0$ of the transmitted microwave by considering an experimental safety factor. Here, as shown in the Equation 2, the inner diameter D2 is set to be below 0.49 x $\lambda_0$.

By satisfying the condition of the Equation 2, the oscillation mode of the microwave transmitted inside of the coaxial waveguide 64 after a mode conversion can be only the TEM mode. That is, it is possible to eliminate other oscillation modes. In other words, the high-order modes except the TEM mode can be blocked by the Equation 2 without generating, for example, the TE mode or a TM mode. In case that the condition of the Equation 2 is not satisfied, it is not desirable since the high-order modes are included and the microwave radiated from the planar antenna member 56 is non-uniformly distributed. As a result, the inner diameter D2 : (2 x r1) of the outer conductor 68 can be maximum about 60 mm, and also, the outer diameter (2 x r2) of the central conductor 66 can be about 30 mm. If the thickness of the central conductor 66 becomes about 2 mm, the inner diameter D1 can be about 26 mm.

Furthermore, as shown in the Equation 3 as the second criteria, it is desirable to set the total length H1, which includes the mode converter 72 and the coaxial waveguide 64, to an odd number multiple of 1/4 wavelength of the atmospheric wavelength $\lambda_0$ of the microwave.

As described above, the height H1 is, specifically, a distance between the partition wall 80A of the ceiling of the mode converter 72 and the ceiling plate of the waveguide box 62. By satisfying the second criteria, the progressive wave which progress through the coaxial waveguide 64 and the reflected wave from the planar antenna member 56 can be cancelled efficiently. As a result, the power efficiency of the microwave for generating plasma can be maintained at a high level. If the condition of the Equation 3 is not satisfied, the reflected wave cannot be cancelled and thus the power efficiency of the microwave is considerably reduced.

Moreover, as shown in the Equation 4 as the third criteria, it is desirable to set the distance H3 between a short-circuit plate 80B, which is an end surface (left end surface of Fig 3.) located in an inner side of the progressive direction of the microwave entering the mode converter 72, and the middle point of the conic surface of the corresponding side of the connection member 82 to a length of an integer multiple of 1/2 wavelength of the atmospheric wavelength $\lambda_0$ of the microwave. Here, the middle point of the cone-shaped inclined surface of the connection member 82 is located on a line extended in the vertical direction of the cylinder-shaped outer conductor 68 of the coaxial waveguide 64.

By satisfying the third criteria, the progressive wave transmitted from the inside of the waveguide 74 and the reflection wave reflected from the short-circuit plate 80B of the mode converter 72 are synchronized to be effectively combined, and the combined wave can progress to the downward coaxial waveguide 64 (by changing its progressive direction by 90 degree). If the condition of the Equation 4 is not satisfied, the progressive wave and the reflection wave reflected from the short-circuit plate 80B are not synchronized to be effectively combined and thus the power efficiency of the microwave is reduced.

As described above, by satisfying the first criteria, the inner diameter of the hollow passage 84 formed in the central conductor can be enlarged while maintaining basic performances regarding the microwave. Also, by satisfying the second and third criteria, the above-mentioned effect can be more improved.

Furthermore, a tolerance of each dimension described in the first to third criteria is about $\pm \lambda_0 / 20$ for the first criteria and about $\pm \lambda_0 / 10$ ($\lambda_0$: the wavelength of the microwave in the atmosphere) for the second and third criteria, respectively. These tolerances do not substantially affect the performances of the coaxial waveguide which propagates the microwave in the TEM mode.

Herein, a simulation is carried out as for the microwave introduction device manufactured based on the first to third criteria and an evaluation thereof is performed. The evaluation results will be described.

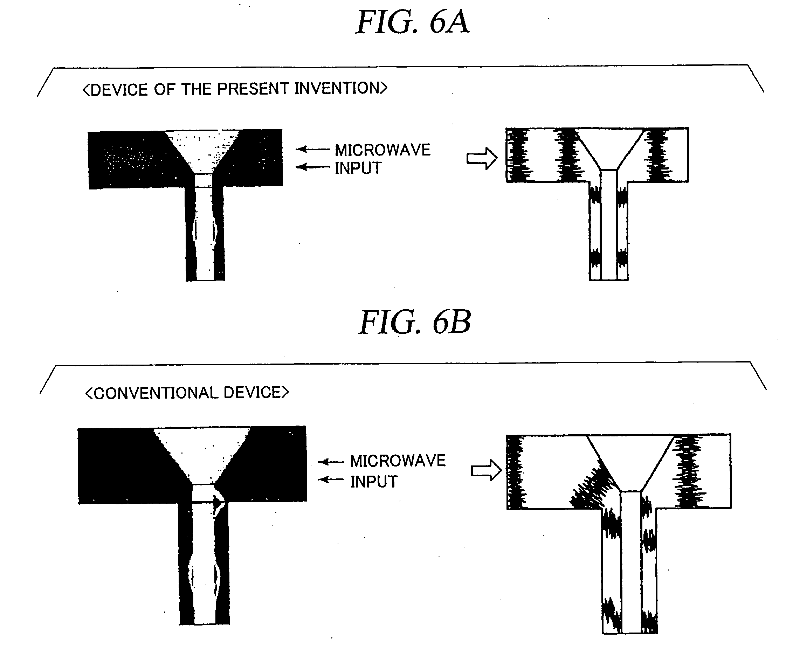

Fig. 6A presents a photograph showing a simulated electric field distribution for the microwave introduction device in accordance with the embodiment of the present invention. Fig. 6B provides a photograph showing a simulated electric field distribution for a conventional microwave introduction device. For easy understanding, a schematic diagram is also depicted, respectively.

In Fig. 6A, an electric field distribution shows bilateral symmetry with respect to the central conductor 66 as a symmetric axis. That is, it can be verified that a good electric field distribution is obtained. In this case, each dimension of the microwave introduction device in Fig. 6A corresponds to r1 = 30 mm, r2 = 15 mm, H1 = 100 mm, and H3 = 50 mm, and satisfies the first to third criteria.

On the contrary, in Fig. 6B, an electric field distribution does not show bilateral symmetry with respect to the central conductor 66 as a symmetric axis, and thus presents an asymmetry. That is, the electric field distribution is not uniform so that a good electric field distribution cannot be obtained. In this case, each dimension of the microwave introduction device in Fig. 6B corresponds to r1 = 75 mm, r2 = 32 mm, H1 = 135 mm, and H3 = 40 mm, and does not satisfy the first to third criteria.

As described above, by satisfying the first criteria at least, the inner diameter of the hollow passage 84 formed in the central conductor 66 can be enlarged while maintaining basic performances regarding the microwave propagation.

Further, by satisfying the second and/or third criteria, an electric field distribution within the inside of the mode converter 72 or the coaxial waveguide 64 is more uniformly optimized so that basic performances regarding the microwave propagation can be more highly maintained.

In addition, although an example of a plasma etching apparatus has been described as a plasma processing apparatus, it is not limited thereto. The present invention can be applied to a plasma CVD apparatus, a plasma ashing apparatus, an oxidation apparatus, a nitridation apparatus, and the like. Further, as a matter of course, the film thickness measuring device 86 can be installed if necessary.

Moreover, in the above-mentioned embodiment, an example of a semiconductor wafer has been explained as a target object to be processed, but it is not limited thereto. The present invention can be applied to a LCD substrate, glass substrate, or ceramic substrate.

**Claims**

1. A microwave introduction device comprising:

   a microwave generator for generating a microwave of a predetermined frequency;
   a mode converter for converting the microwave into a predetermined oscillation mode;
   a planar antenna member arranged toward a predetermined space; and
   a coaxial waveguide connecting the mode converter with the planar antenna member to propagate the microwave,
   wherein a central conductor of the coaxial waveguide is formed in a cylindrical shape,
   an inner diameter D1 of the central conductor is not smaller than a first predetermined value,
   an outer conductor of the coaxial waveguide is also formed in a cylindrical shape,
   a ratio r1/r2 of a radius r1 of an inner diameter of the outer conductor to a radius r2 of an outer diameter of the central conductor is maintained at a second predetermined value, and
   the inner diameter D2 of the outer conductor is not greater than a third predetermined value.

2. The microwave introduction device of claim 1, wherein a through hole communicated with the inside of the cylinder-shaped central conductor is formed at a center portion of the planar antenna member.

3. The microwave introduction device of claim 1 or 2,
   wherein the predetermined oscillation mode is a TEM mode.

4. The microwave introduction device of any one of claims 1 to 3, wherein the first predetermined value is about 16 mm.

5. The microwave introduction device of any one of claims 1 to 4, wherein the second predetermined value is a fixed value within the range of about $e^{2/3}$ to $e(e = 2.718...)$.

6. The microwave introduction device of claim 5, wherein a characteristic impedance obtained based on the ratio r1/r2 is within the range of about 40 to 60 $\Omega$.

7. The microwave introduction device of any one of claims 1 to 6, wherein the third predetermined value is a (0.59 - 0.1) wavelength of a wavelength $\lambda_0$ of the microwave under the atmospheric pressure.

8. The microwave introduction device of any one of claims 1 to 7, wherein the entire length including the mode converter and the coaxial waveguide is set to an odd number multiple of 1/4 wavelength of a wavelength $\lambda_0$ of the microwave under the atmospheric pressure.

9. The microwave introduction device of any one of claims 1 to 8, wherein a base end of the central conductor is provided via a cone-shaped connection member formed on a partition wall of the mode converter, and a distance between an end surface located in an inner side of a progressive direction of the microwave entering the mode converter and a middle point of an inclined surface of the cone-shaped connection member is set to a length of an integer multiple of 1/2 wavelength of a wavelength $\lambda_0$ of the microwave under the atmospheric pressure.

10. The microwave introduction device of any one of claims 1 to 9, wherein an inner diameter D1 of the central conductor is not smaller than about 18 mm.

11. The microwave introduction device of any one of claims 1 to 10, wherein the frequency of the microwave is about 2.45 GHz.

12. The microwave introduction device of any one of claims 1 to 11, wherein, on a top surface of the planar antenna member, a slow-wave member is installed.

13. A plasma processing apparatus comprising:

a processing chamber whose ceiling portion is opened and the inside thereof can be evacuated to vacuum;
a mounting table, installed in the processing chamber, for mounting a target object to be processed;
a ceiling plate which is made of a microwave transmissive dielectric material and is airtightly mounted to an opening of the ceiling portion;
a gas introduction unit for introducing a predetermined gas into the processing chamber; and
a microwave introduction device as claimed in any one of claims 1 to 11, disposed on the ceiling plate, for generating plasma in the processing chamber by a microwave.

14. The plasma processing apparatus of claim 13, wherein, installed at the microwave introduction device is a film thickness measuring device for measuring a thickness of a film on a surface of the target object by emitting a laser beam along a hollow passage of the central conductor of the coaxial waveguide in the microwave introduction device.

# *FIG. 1*

MICROWAVE
GENERATOR
(2.45GHz)

VACUUM EVACUATION

# FIG. 2

# FIG. 3

## FIG. 4

## FIG. 5

TE MODE

# FIG. 6A

<DEVICE OF THE PRESENT INVENTION>

← MICROWAVE
← INPUT

# FIG. 6B

<CONVENTIONAL DEVICE>

← MICROWAVE
← INPUT

EP 1 959 484 A1

# FIG. 7

VACUUM EVACUATION          VACUUM EVACUATION

## INTERNATIONAL SEARCH REPORT

| | International application No. |
|---|---|
| | PCT/JP2006/322749 |

**A. CLASSIFICATION OF SUBJECT MATTER**
*H01L21/3065(2006.01)i, H05H1/46(2006.01)i*

According to International Patent Classification (IPC) or to both national classification and IPC

**B. FIELDS SEARCHED**

Minimum documentation searched (classification system followed by classification symbols)
H01L21/3065, H05H1/46

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2003-234327 A (Tokyo Electron Ltd.), | 1-3,7,8, |
| | 22 August, 2003 (22.08.03), | 11-13 |
| Y | Par. Nos. [0025] to [0030] | 4-6,9,10 |
| A | & US 2005/082004 A1 & WO 2003/067939 A1 | 14 |
| | & CN 1628495 A | |
| | | |
| Y | JP 09-102486 A (Matsushita Electric Industrial Co., Ltd.), | 4-6,9,10 |
| | 15 April, 1997 (15.04.97), | |
| | Par. Nos. [0017] to [0028] | |
| | (Family: none) | |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 09 February, 2007 (09.02.07) | 20 February, 2007 (20.02.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

## REFERENCES CITED IN THE DESCRIPTION

**Patent documents cited in the description**

- JP H3191073 B
- JP H5343334 B
- JP H9181052 B
- JP 2003332326 A

**Non-patent literature cited in the description**

- Morikita Electrical Engineering Series 3. **NAKAJIMA MASAMITSU.** Microwave Optics - Foundation and Principles. Morikita Publication, 18 December 1998